# EUROPEAN PATENT APPLICATION

(11) **EP 3 962 057 A1**
(43) Date of publication of application: **02.03.2022**
(21) Application number: 20822766.0
(22) Date of filing: 10.06.2020
(51) Int. Cl.: H04N 5/225, G01N 21/35

(54) **IMAGE SENSOR, AND IMAGE PHOTOGRAPHING APPARATUS AND METHOD**

(30) Priority: 13.06.2019 CN 201910510241
(71) Applicant: Huawei Technologies Co., Ltd., Shenzhen, Guangdong 518129 (CN)
(72) Inventor: ZHU, Liyu, Shenzhen, Guangdong 518129 (CN)
(74) Representative: Gill Jennings & Every LLP
(86) International application number: PCT/CN2020/095348
(87) International publication number: WO 2020/249000

(57) **Abstract**

This application relates to the image photographing field, and discloses an image sensor and an image photographing apparatus and method, to obtain spectrum information without adding a peripheral. The image photographing apparatus includes an image sensor and a processor. The image sensor is configured to photograph at least one image of an object. The processor is configured to: obtain an image of the object under a preset light source based on the at least one image; for the image of the object under the preset light source, calculate a difference between sub-images of filter points at same corresponding positions in any two filter arrays in a first filter array set, to obtain a plurality of narrowband spectrum responses of the first filter array set; and obtain spectrum information of the object in the first filter array set based on the plurality of narrowband spectrum responses.

## Description

This application claims priority to Chinese patent application No. 201910510241.3, filed with the China National Intellectual Property Administration on June 13, 2019 and entitled "IMAGE SENSOR AND IMAGE PHOTOGRAPHING APPARATUS AND METHOD", which is incorporated herein by reference in its entirety.

### TECHNICAL FIELD

This application relates to the image photographing field, and in particular, to an image sensor and an image photographing apparatus and method.

### BACKGROUND

With progress of image photographing technologies and development of image processing applications, during image photographing, an image photographing apparatus (for example, a mobile phone) not only obtains basic red green blue (red green blue, RGB) information, but may also obtain spectrum information.

In the conventional technology, spectrum information is usually obtained by using a special-purpose spectrometer or an external optical device. A common user usually does not purchase such a device. This limits application of spectrum information.

### SUMMARY

Embodiments of this application provide an image sensor and an image photographing apparatus and method, to obtain spectrum information without adding a peripheral.

To achieve the foregoing objective, the embodiments of this application use the following technical solutions:

According to a first aspect, an image sensor is provided, including a color filter array, where the color filter array includes at least one filter array set, each filter array set includes at least two filter arrays, and filter points at same corresponding positions in filter arrays in a same filter array set are used to filter a same type of light ray component but have different spectrum pass curves in filtering. According to the image sensor provided in this embodiment of this application, because filter points at same corresponding positions in filter arrays in a same filter array set are used to filter a same type of light ray component but have different spectrum pass curves in filtering, for an image of an object under a preset light source, a difference between sub-images of filter points at same corresponding positions in any two filter arrays in a first filter array set may be calculated, to obtain a plurality of narrowband spectrum responses of the first filter array set; and spectrum information of the object in the first filter array set is obtained based on the plurality of narrowband spectrum responses. A filter array of the image sensor is modified and the image sensor is matched with a corresponding image processing algorithm, thereby obtaining the spectrum information without adding a peripheral.

In a possible implementation, the filter arrays are bayer patterns.

According to a second aspect, an image photographing apparatus is provided, including the image sensor according to either the first aspect or the implementation of the first aspect and a processor. The image sensor is configured to photograph at least one image of an object. The processor is configured to: obtain an image of the object under a preset light source based on the at least one image; for the image of the object under the preset light source, calculate a difference between sub-images of filter points at same corresponding positions in any two filter arrays in a first filter array set, to obtain a plurality of narrowband spectrum responses of the first filter array set; and obtain spectrum information of the object in the first filter array set based on the plurality of narrowband spectrum responses. According to the image photographing apparatus provided in this embodiment of this application, the image sensor is configured to photograph the at least one image of the object, and the processor is configured to obtain the image of the object under the preset light source based on the at least one image. Because filter points at same corresponding positions in filter arrays in a same filter array set are used to filter a same type of light ray component but have different spectrum pass curves in filtering, for the image of the object under the preset light source, the difference between the sub-images of the filter points at the same corresponding positions in the any two filter arrays in the first filter array set may be calculated, to obtain the plurality of narrowband spectrum responses of the first filter array set; and the spectrum information of the object in the first filter array set is obtained based on the plurality of narrowband spectrum responses. A filter array of the image sensor is modified and the image sensor is matched with a corresponding image processing algorithm, thereby obtaining the spectrum information without adding a peripheral.

In a possible implementation, the at least one image includes a first image and a second image, the first image is an image that is of the object and that has not received fill lighting from the preset light source, and the second image is an image that is of the object and that has received fill lighting from the preset light source; and the processor is configured to calculate a difference between the second image and the first image, to obtain the image of the object under the preset light source. This implementation is applicable when ambient light is poor (for example, on a cloudy day, at night, or indoors).

In a possible implementation, the at least one image includes a third image; and the processor is configured to calibrate the third image based on a preset white balance parameter, to obtain the image of the object under the preset light source. This implementation is applicable when ambient light is good (for example, on a sunny day, at noon, or outdoors).

In a possible implementation, the processor is specifically configured to perform interpolation on the plurality of narrowband spectrum responses, to obtain the spectrum information of the object in the first filter array set.

In a possible implementation, the processor is further configured to correct, by using a color correction matrix (CCM), a sub-image corresponding to each filter array of the at least one image. After white balancing is implemented, sub-images corresponding to the filter arrays are demarcated by using different CCMs, to be corrected to same color space, so that normal photographing is not affected.

According to a third aspect, an image photographing method is provided, applied to the image photographing apparatus according to any one of the second aspect or the implementations of the second aspect. The method includes: photographing at least one image of an object; obtaining an image of the object under a preset light source based on the at least one image; and for the image of the object under the preset light source, calculating a difference between sub-images of filter points at same corresponding positions in any two filter arrays in a first filter array set, to obtain a plurality of narrowband spectrum responses of the first filter array set; and obtaining spectrum information of the object in the first filter array set based on the plurality of narrowband spectrum responses.

In a possible implementation, the at least one image includes a first image and a second image, the first image is an image that is of the object and that has not received fill lighting from the preset light source, and the second image is an image that is of the object and that has received fill lighting from the preset light source; and the obtaining an image of the object under a preset light source based on the at least one image includes: calculating a difference between the second image and the first image, to obtain the image of the object under the preset light source.

In a possible implementation, the at least one image includes a third image; and the obtaining an image of the object under a preset light source based on the at least one image includes: calibrating the third image based on a preset white balance parameter, to obtain the image of the object under the preset light source.

In a possible implementation, the obtaining spectrum information of the object in the first filter array set based on the plurality of narrowband spectrum responses includes: performing interpolation on the plurality of narrowband spectrum responses, to obtain the spectrum information of the object in the first filter array set.

In a possible implementation, the method further includes: correcting, by using a color correction matrix (CCM), a sub-image corresponding to each filter array of the at least one image.

For technical effects of the third aspect and any implementation of the third aspect, refer to the second aspect.

### BRIEF DESCRIPTION OF DRAWINGS

FIG. 1 is a schematic structural diagram of an image photographing apparatus according to an embodiment of this application;
FIG. 2 is a schematic structural diagram of an image sensor according to an embodiment of this application;
FIG. 3 is a schematic diagram of spectrum pass curves of an image sensor according to an embodiment of this application;
FIG. 4 is a schematic structural diagram of another image sensor according to an embodiment of this application;
FIG. 5 is a schematic diagram of spectrum pass curves of filter points at same corresponding positions in different filter arrays according to an embodiment of this application;
FIG. 6 is a schematic flowchart of an image photographing method according to an embodiment of this application; and
FIG. 7 is a schematic diagram of a narrowband spectrum response according to an embodiment of this application.

### DESCRIPTION OF EMBODIMENTS

This application provides an image photographing apparatus. The image photographing apparatus may be an apparatus that has a photographing function, for example, a mobile phone, a tablet computer, or a camera.

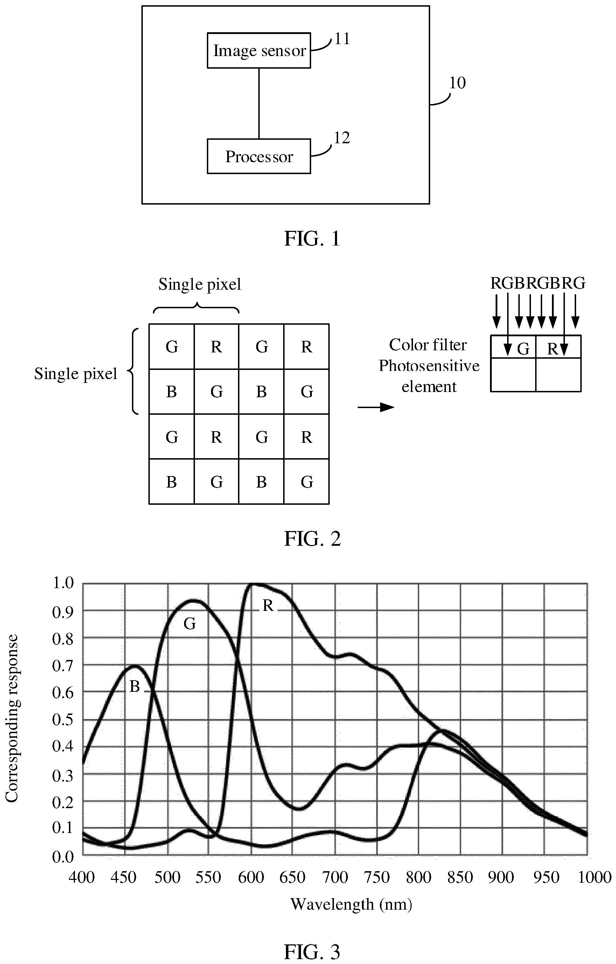

As shown in FIG. 1, the image photographing apparatus 10 includes an image sensor 11 and a processor 12. Optionally, the image photographing apparatus 10 may further include a memory.

The memory in this embodiment of this application may be a volatile memory or a nonvolatile memory, or may include a volatile memory and a nonvolatile memory. The nonvolatile memory may be a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), or a flash memory. The volatile memory may be a random access memory (random access memory, RAM), used as an external cache. Through example but not limitative description, many forms of RAMs may be used, for example, a static random access memory (static RAM, SRAM), a dynamic random access memory (dynamic RAM, DRAM), a synchronous dynamic random access memory (synchronous DRAM, SDRAM), a double data rate synchronous dynamic random access memory (double data rate SDRAM, DDR SDRAM), an enhanced synchronous dynamic random access memory (enhanced SDRAM, ESDRAM), a synchronous link dynamic random access memory (synchlink DRAM, SLDRAM), and a direct rambus random access memory (direct rambus RAM, DR RAM).

The processor 12 in this embodiment of this application may be a dedicated image processor or a general-purpose processor, for example, may be an image signal processor (image signal processor, ISP) or another processor that has an image processing function.

The image sensor 11 in this embodiment of this application may be a charge-coupled device (charge-coupled device, CCD), a complementary metal oxide semiconductor (complementary metal oxide semiconductor, CMOS), or another sensor that has an image collection function.

As shown in FIG. 2, an image sensor in the conventional technology usually uses a color filter array (color filter array, CFA) of a bayer pattern. A single pixel in the image sensor includes four filter points (RGGB filter points), and each filter point includes a color filter and a photosensitive element. The color filters each perform filtering on wide-spectrum incident light based on an RGB light ray component. The photosensitive element senses only a single light ray component that is filtered by the color filter.

FIG. 3 shows spectrum pass curves of an image sensor in the conventional technology. An output value of a single filter point is in direct proportion to a product of an integral value of a spectrum pass curve and an incident light spectrum. Same light ray components of pixels have a same spectrum pass curve.

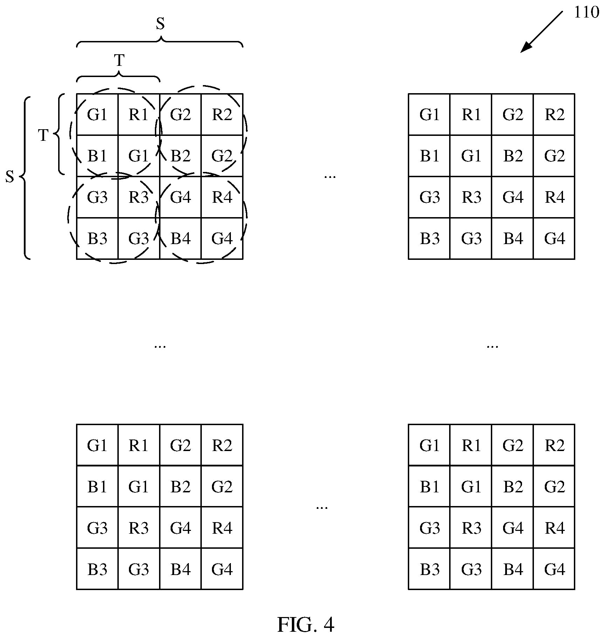

As shown in FIG. 4, the image sensor 11 in this embodiment of this application includes a color filter array (color filter array, CFA) 110. The color filter array includes at least one filter array set S, each filter array set S includes at least two filter arrays T, and filter points at same corresponding positions in filter arrays T in a same filter array set S are used to filter a same type of light ray component but have different spectrum pass curves in filtering. Particularly, the filter arrays may be bayer patterns (bayer patterns).

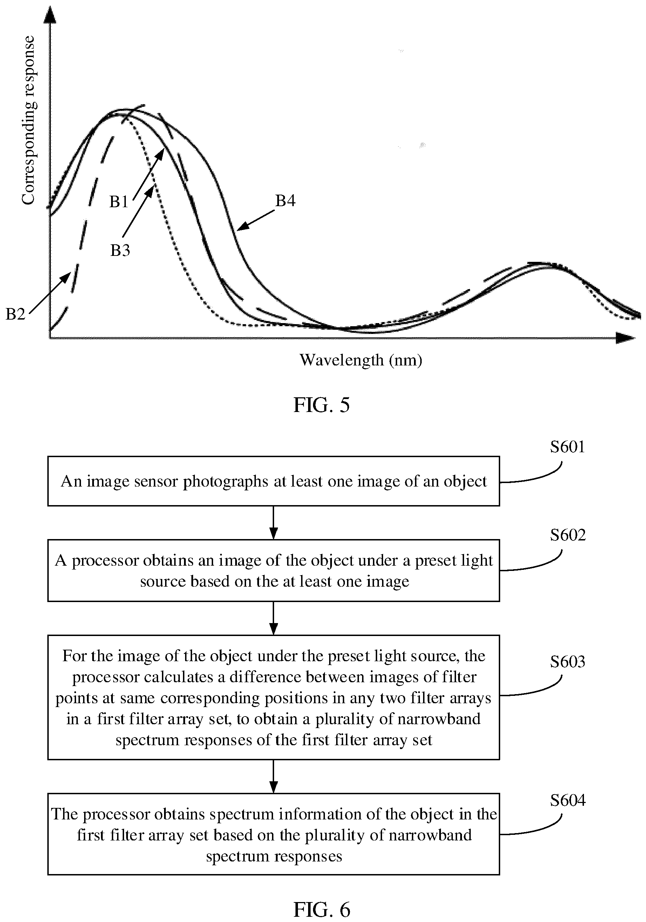

For example, each filter array set S in FIG. 4 includes four filter arrays T. G1, G2, G3, and G4 are all used to filter green light ray components. However, G1, G2, G3, and G4 have different spectrum pass curves. R1, R2, R3, and R4 are all used to filter red light ray components. However, R1, R2, R3, and R4 have different spectrum pass curves. B1, B2, B3, and B4 are all used to filter blue light ray components. However, B1, B2, B3, and B4 have different spectrum pass curves. For example, FIG. 5 shows a difference between the spectrum pass curves of B1, B2, B3, and B4.

The image sensor 11 and the processor 12 are configured to perform an image photographing method shown in FIG. 6.

S601. An image sensor photographs at least one image of an object.

In a possible implementation, when ambient lighting is poor (for example, on a cloudy day, at night, or indoors), the image sensor may photograph two images of the object. To be specific, the at least one image includes a first image and a second image, the first image is an image that is of the object and that has not received fill lighting from a preset light source, and the second image is an image that is of the object and that has received fill lighting from the preset light source.

In other words, in a process in which an image photographing apparatus photographs the images of the object by using the image sensor, two exposures are made in sequence. During first photographing, no fill light is used to provide fill lighting, and the image that is of the object and that has not received fill lighting from the preset light source is obtained. The image includes only ambient light. During second photographing, a same exposure parameter is used, a fill light of the preset light source is used to provide fill lighting, and the image that is of the object and that has received fill lighting from the preset light source is obtained. The image not only includes ambient light, but also includes the fill lighting from the preset light source.

In another possible implementation, when ambient light is good (for example, on a sunny day, at noon, or outdoors), the image sensor may photograph only one image of the object. To be specific, the at least one image includes a third image.

It should be noted that a sequence of photographing the first image and the second image is not limited in this application. Alternatively, the second image may be photographed before the first image.

S602. A processor obtains an image of the object under the preset light source based on the at least one image.

In a possible implementation, when the image sensor photographs the first image and the second image, the processor may calculate a difference between the second image and the first image, to obtain the image of the object under the preset light source. In other words, calculating the difference between the second image and the first image removes the ambient light while retaining only the image of the object under the preset light source.

In another possible implementation, when the image sensor photographs the third image, the processor calibrates the third image based on a preset white balance parameter, to obtain the image of the object under the preset light source. Different filter arrays in a same filter array set have different white balance parameters. To be specific, white balance calibration and color correction are performed on a sub-image corresponding to each filter array.

S603. For the image of the object under the preset light source, the processor calculates a difference between sub-images of filter points at same corresponding positions in any two filter arrays in a first filter array set, to obtain a plurality of narrowband spectrum responses of the first filter array set.

The first filter array set is any filter array set.

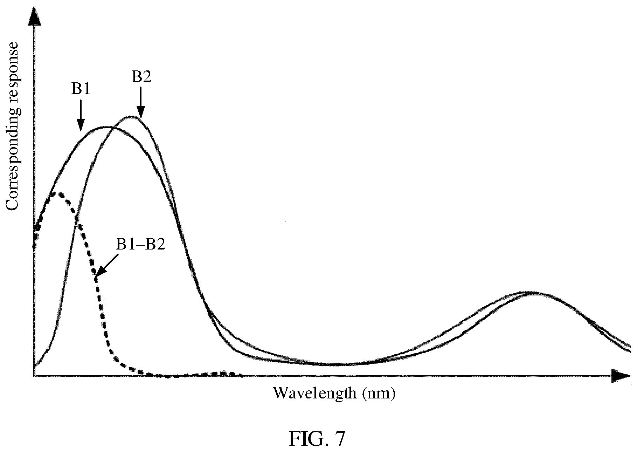

In an example of blue filter points in a first filter array set in filter array sets shown in FIG. 4, a difference between every two sub-images of filter points B1, B2, B3, and B4 in the filter array set may be calculated to obtain a total of six narrowband spectrum responses: B1-B2, B 1-B3, B 1-B4, B2-B3, B2-B4, and B3-B4. For example, FIG. 7 is a schematic diagram of the narrowband spectrum response B 1-B2.

S604. The processor obtains spectrum information of the object in the first filter array set based on the plurality of narrowband spectrum responses.

Specifically, interpolation is performed on the plurality of narrowband spectrum responses of the first filter array set, to obtain the spectrum information of the object in the first filter array set.

For example, interpolation may be performed on the six narrowband spectrum responses obtained in step S603, to obtain blue spectrum information of the object in the first filter array set.

In addition, filter points at same corresponding positions in filter arrays in a same filter array set have different spectrum pass curves. Therefore, imaging color responses of the filter arrays are inconsistent during normal photographing. Therefore, the processor is further configured to correct, by using a color correction matrix (color correction matrix, CCM), a sub-image corresponding to each filter array of the at least one image. Different filter arrays in a same filter array set have different CCMs. To be specific, after white balancing is implemented, sub-images corresponding to the filter arrays are demarcated by using different CCMs, to be corrected to same color space, so that normal photographing is not affected.

According to the image sensor and the image photographing apparatus and method provided in the embodiments of this application, the image sensor is configured to photograph the at least one image of the object, and the processor is configured to obtain the image of the object under the preset light source based on the at least one image. Because filter points at same corresponding positions in filter arrays in a same filter array set are used to filter a same type of light ray component but have different spectrum pass curves in filtering, for the image of the object under the preset light source, the difference between the sub-images of the filter points at the same corresponding positions in the any two filter arrays in the first filter array set may be calculated, to obtain the plurality of narrowband spectrum responses of the first filter array set; and the spectrum information of the object in the first filter array set is obtained based on the plurality of narrowband spectrum responses. A filter array of the image sensor is modified and the image sensor is matched with a corresponding image processing algorithm, thereby obtaining the spectrum information without adding a peripheral.

It should be understood that sequence numbers of the foregoing processes do not mean execution sequences in the embodiments of this application. The execution sequences of the processes should be determined based on functions and internal logic of the processes, and should not be construed as any limitation on the implementation processes of the embodiments of this application.

A person of ordinary skill in the art may be aware that, in combination with the examples described in the embodiments disclosed in this specification, units and algorithm steps may be implemented by electronic hardware or a combination of computer software and electronic hardware. Whether the functions are performed by hardware or software depends on particular applications and design constraints of the technical solutions. A person skilled in the art may use different methods to implement the described functions for each particular application, but it should not be considered that the implementation goes beyond the scope of this application.

It may be clearly understood by a person skilled in the art that, for the purpose of convenient and brief description, for a detailed working process of the foregoing system, apparatus, and unit, refer to a corresponding process in the foregoing method embodiments, and details are not described herein again.

In the several embodiments provided in this application, it should be understood that the disclosed system, device, and method may be implemented in other manners. For example, the described device embodiment is merely an example. For example, the unit division is merely logical function division and may be other division in actual implementation. For example, a plurality of units or components may be combined or integrated into another system, or some features may be ignored or not performed. In addition, the displayed or discussed mutual couplings or direct couplings or communication connections may be implemented through some interfaces. The indirect couplings or communication connections between the devices or units may be implemented in electronic, mechanical, or other forms.

The units described as separate parts may or may not be physically separate, and parts displayed as units may or may not be physical units, may be located in one position, or may be distributed on a plurality of network units. Some or all of the units may be selected based on actual requirements to achieve the objectives of the solutions of the embodiments.

In addition, functional units in the embodiments of this application may be integrated into one processing unit, or each of the units may exist alone physically, or two or more units may be integrated into one unit.

All or some of the foregoing embodiments may be implemented by using software, hardware, firmware, or any combination thereof. When a software program is used to implement the embodiments, all or some of the embodiments may be implemented in a form of a computer program product. The computer program product includes one or more computer instructions. When the computer program instructions are loaded and executed on a computer, the procedure or functions according to the embodiments of this application are all or partially generated. The computer may be a general-purpose computer, a dedicated computer, a computer network, or another programmable apparatus. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line (Digital Subscriber Line, DSL)) or wireless (for example, infrared, radio, or microwave) manner. The computer-readable storage medium may be any usable medium accessible by a computer, or a data storage device, such as a server or a data center, integrating one or more usable media. The usable medium may be a magnetic medium (for example, a floppy disk, a hard disk, or a magnetic tape), an optical medium (for example, a DVD), a semiconductor medium (for example, a solid-state drive (Solid-State Drive, SSD)), or the like.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. An image sensor, comprising a color filter array, wherein the color filter array comprises at least one filter array set, each filter array set comprises at least two filter arrays, and filter points at same corresponding positions in filter arrays in a same filter array set are used to filter a same type of light ray component but have different spectrum pass curves in filtering.

2. The image sensor according to claim 1, wherein the filter arrays are bayer patterns.

3. An image photographing apparatus, comprising the image sensor according to either of claims 1 and 2 and a processor, wherein
the image sensor is configured to photograph at least one image of an object; and
the processor is configured to: obtain an image of the object under a preset light source based on the at least one image; and for the image of the object under the preset light source, calculate a difference between sub-images of filter points at same corresponding positions in any two filter arrays in a first filter array set, to obtain a plurality of narrowband spectrum responses of the first filter array set; and
obtain spectrum information of the object in the first filter array set based on the plurality of narrowband spectrum responses.

4. The image photographing apparatus according to claim 3, wherein the at least one image comprises a first image and a second image, the first image is an image that is of the object and that has not received fill lighting from the preset light source, and the second image is an image that is of the object and that has received fill lighting from the preset light source; and
the processor is configured to calculate a difference between the second image and the first image, to obtain the image of the object under the preset light source.

5. The image photographing apparatus according to claim 3, wherein the at least one image comprises a third image; and
the processor is configured to calibrate the third image based on a preset white balance parameter, to obtain the image of the object under the preset light source.

6. The image photographing apparatus according to any one of claims 3 to 5, wherein the processor is specifically configured to perform interpolation on the plurality of narrowband spectrum responses, to obtain the spectrum information of the object in the first filter array set.

7. The image photographing apparatus according to any one of claims 3 to 6, wherein the processor is further configured to correct, by using a color correction matrix, CCM, a sub-image corresponding to each filter array of the at least one image.

8. An image photographing method, applied to the image photographing apparatus according to any one of claims 3 to 7, wherein the method comprises:
photographing at least one image of an object;
obtaining an image of the object under a preset light source based on the at least one image; and for the image of the object under the preset light source, calculating a difference between sub-images of filter points at same corresponding positions in any two filter arrays in a first filter array set, to obtain a plurality of narrowband spectrum responses of the first filter array set; and
obtaining spectrum information of the object in the first filter array set based on the plurality of narrowband spectrum responses.

9. The image photographing method according to claim 8, wherein the at least one image comprises a first image and a second image, the first image is an image that is of the object and that has not received fill lighting from the preset light source, and the second image is an image that is of the object and that has received fill lighting from the preset light source; and the obtaining an image of the object under a preset light source based on the at least one image comprises:
calculating a difference between the second image and the first image, to obtain the image of the object under the preset light source

10. The image photographing method according to claim 8, wherein the at least one image comprises a third image; and the obtaining an image of the object under a preset light source based on the at least one image comprises:
calibrating the third image based on a preset white balance parameter, to obtain the image of the object under the preset light source.

11. The image photographing method according to any one of claims 8 to 10, wherein the obtaining spectrum information of the object in the first filter array set based on the plurality of narrowband spectrum responses comprises:
performing interpolation on the plurality of narrowband spectrum responses, to obtain the spectrum information of the object in the first filter array set.

12. The image photographing method according to any one of claims 8 to 11, wherein the method further comprises:
correcting, by using a color correction matrix, CCM, a sub-image corresponding to each filter array of the at least one image.
